# EUROPEAN PATENT SPECIFICATION

(11) **EP 0 529 820 B1**
(45) Date of publication and mention of the grant of the patent: **17.04.1996**
(21) Application number: 92307044.5
(22) Date of filing: 03.08.1992
(51) Int. Cl.: H01L 23/525

(54) **Elevated metal-to-metal antifuse structures and fabrication processes**
Erhöhte Metall-Metall-Antischmelzsicherungsstrukturen und Verfahren zu deren Herstellung
Structures antifusibles intermétalliques et procédé de fabrication

(30) Priority: 26.08.1991 US 749866
(43) Date of publication of application: 03.03.1993
(73) Proprietor: ACTEL CORPORATION, Sunnyvale California 94086 (US)
(72) Inventor: Hawley, Frank W., Campbell, California 95008 (US); McCollum, John L., Saratoga, California 95070 (US)
(74) Representative: Senior, Alan Murray

(56) References cited:
- US-A- 4 914 055
- US-A- 5 006 673

## Description

### BACKGROUND OF THE INVENTION

### 1. Field Of The Invention

The present invention relates to user-programmable interconnect elements and to antifuses. More particularly, the present invention relates to metal-to-metal antifuses which may be disposed between two metal interconnect layers in microcircuit structures such as integrated circuits.

### 2. The Prior Art

Antifuse structures may be disposed between two metal layers in a microcircuit structure which act as the upper and lower antifuse electrodes. These antifuse structures are characterized by a via or cell opening disposed in a dielectric layer between the two metal layers, into which a suitable antifuse material is deposited. Prior to programming, the antifuse presents a very high impedance between the upper and lower electrodes. After programming, a conductive path is formed between the upper and lower electrodes in the antifuse material having an impedance of less than a few hundred ohms. US 4 914 055 discloses a method for forming an array of such antifuse structures.

On the one hand, it is desirable to provide a thick inter-metal dielectric layer in order to minimize the inter-metal capacitance and the capacitance of unprogrammed antifuse structures. On the other hand, this objective competes with the ability to manufacture the antifuse structures.

It has been found that scaling problems occur when depositing antifuse material, such as PECVD amorphous silicon, into deep (i.e., more than about 0.4 microns), small width (i.e., less than about 1.5 microns) cell openings. These scaling problems manifest themselves by reduced breakdown voltages and increased current leakage in the antifuse structures. As the aspect ratio (cell width versus. cell depth) of the antifuse cell opening decreases, the scaling problems get worse. This is due in part to the reduced step coverage (final thickness) of the antifuse material at the bottom of the antifuse cell opening. As the depth of the cell opening increases and/or the width decreases, the step coverage deteriorates, thus exacerbating the scaling problems.

### BRIEF DESCRIPTION OF THE INVENTION

According to the present invention, a metal-to-metal antifuse structure is fabricated by the process defined in claim 1, which reduces the small geometry effects found in the standard cell opening antifuse structures. The antifuse structure of the present invention as defined in claim 6 minimizes these small geometry scaling effects by decreasing the depth of the antifuse cell opening while maintaining all other advantages of the standard antifuse structure.

### BRIEF DESCRIPTION OF THE DRAWINGS

FIG. 1 is a cross sectional view of a metal-to-metal antifuse fabricated in accordance with an embodiment of the present invention.

FIGS. 2a-2d are cross sectional views of the antifuse depicted in FIG. 1, progressively illustrating the fabrication process according to a presently preferred embodiment of the invention.

### DETAILED DESCRIPTION OF A PREFERRED EMBODIMENT

Those of ordinary skill in the art will realize that the following description of the present invention is illustrative only and not in any way limiting. Other embodiments of the invention will readily suggest themselves to such skilled persons from reading the within disclosure. Such persons will also recognize that well known semiconductor and materials processing techniques may be employed to create the structures disclosed herein. The details of such well known processing steps will not be set forth herein in order to avoid overcomplicating the disclosure and thus obscuring the present invention.

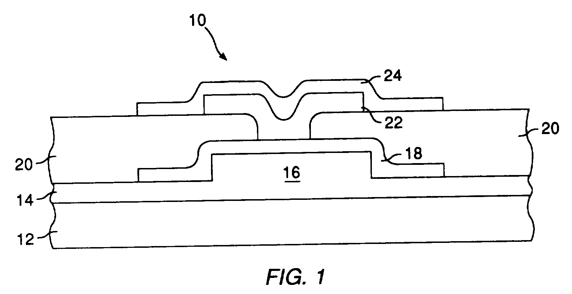

Referring first to FIG. 1, a metal-to-metal antifuse according to a first embodiment of the present invention is fabricated upon a pedestal. Antifuse 10 is disposed upon a suitable substrate 12. Where necessary because of the conductive nature of the substrate or to promote adhesion of overlying layers, substrate 12 may be covered with a dielectric layer 14.

Antifuse 10 is disposed over a pedestal 16 formed on either dielectric layer 14 or substrate 12 by suitable steps, such as etching part of the material away, leaving pedestal 16. In a presently preferred embodiment of the invention, pedestal 16 may have a height of between about 0.2 to 0.6 microns, preferably about 0.4 microns.

Lower electrode 18 for antifuse 10 is formed over pedestal 16. According to a presently preferred embodiment, lower electrode 18 may comprise a layer of TiW, having a thickness of about 0.3 microns, or may comprise another metallic film. Those of ordinary skill in the art will recognize that lower electrode 18 may be a portion of a metal interconnect layer in a microcircuit such as an integrated circuit.

An inter-metal dielectric layer 20 lies over lower electrode 18 and is planarized such that it has a thickness of about between 0.2 to 0.6 microns, preferably about 0.4 microns, above pedestal 16 and a thickness of between about 0.6 to 1.0 microns, preferably about 0.8 microns in regions off the pedestal 16.

An antifuse cell opening is formed in inter-metal dielectric 20 and a layer of antifuse material 22 is disposed therein in contact with lower electrode 18. According to a presently preferred embodiment, antifuse material 22 may comprise a layer of amorphous silicon having a thickness of between about 0.1 to 0.5 microns, preferably about 0.15 microns. Those of ordinary skill in the art will recognize that other known antifuse materials may be used to form the antifuse of the present invention.

An upper antifuse electrode is disposed above inter-metal dielectric layer 20 and antifuse material 22. According to a presently preferred embodiment, upper electrode may comprise a layer of TiW or other metallic film having a thickness of between about 0.1 to 0.5 microns. A layer 24 of interconnect material, such as aluminum, may be placed over the TiW layer to serve as a metal interconnect layer as is known in the art.

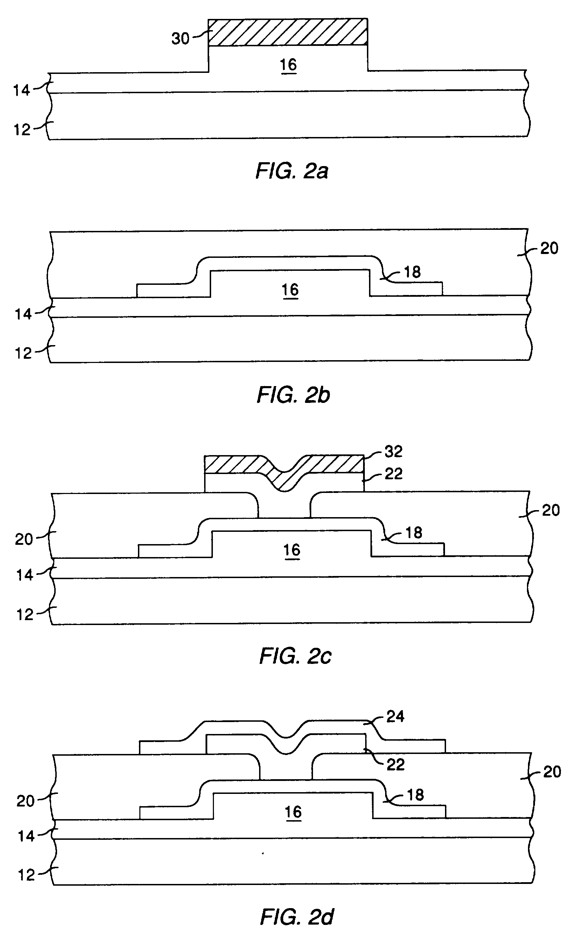

Referring now to FIGS. 2a-2d, a process according to the present invention is illustrated using progressive cross-sectional views of the antifuse structure at selected points in the fabrication process. As shown in FIG. 2a, the process begins by forming pedestal 16 on dielectric layer 14 or substrate 12. As those of ordinary skill in the art will appreciate, pedestal 16 may be created by masking the region of pedestal 16 with a suitable photomask 30 and then etching the exposed regions of insulating layer 14 with a conventional etching step. FIG. 2a shows the structure resulting after formation of the pedestal and prior to removal of photomask 30.

Referring now to FIG. 2b, first metal layer 18 is formed over the surface of the insulating layer 14 and a portion of it rests on the top of pedestal 16. This portion of the first metal layer 18 will serve as the lower antifuse electrode. First metal layer 18 is then defined using appropriate well-known processing techniques. First metal layer 18 may comprise a layer of TiW having a thickness of between about 0.1 and 0.5, preferably about 0.3 microns, and may comprise other metallic films.

Next, an inter-metal dielectric layer 20 is formed and planarized using known processing techniques. Inter-metal dielectric layer 20 may comprise a layer of PECVD silicon dioxide formed such that, after planarization, it has a thickness of about between 0.2 to 0.6 microns, preferably about 0.4 microns, over pedestal 16 and a thickness of between about 0.6 to 1.0 microns, preferably about 0.8 microns in regions other than over pedestal 16.

Referring now to FIG. 2c, an antifuse cell opening is formed in the planarized inter-metal dielectric layer 20 and a layer of antifuse material 22 is formed. In a presently preferred embodiment of the invention, antifuse material 22 may comprise a layer of amorphous silicon having a thickness of about between 0.1 to 0.5 microns. Those of ordinary skill in the art will realize that it might be advantageous to round the edges of the cell opening prior to forming the antifuse material 22. This may be done using known techniques, such as a wet etch or resist erosion dry etch.

An upper electrode is formed over the top of antifuse material 22, and may comprise a layer of TiW having a thickness of about 0.1 microns. The upper electrode and the antifuse material 22 are patterned and defined using conventional processing steps including a photomask 32. FIG. 2c shows the structure resulting after the performance of these steps but prior to removal of photomask 32 used to define upper antifuse electrode 24 and antifuse material 22.

Referring now to FIG. 2d, a second metal layer 24 is formed and defined over inter-metal dielectric layer 20 and upper antifuse electrode. In a presently preferred embodiment, this second metal layer 24 may comprise a layer of TiW having a thickness of between about 0.1 to 0.3 microns, although those of ordinary skill in the art will realize that other metal films and thicknesses may be employed. A metal layer such as aluminum having a thickness of about between 0.4 to 1.0 microns, preferably about 0.8 microns, may be formed over the TiW layer to serve as a metal interconnect layer. Conventional back-end processing may be employed to complete the structure containing antifuse 10.

From the above description, those of ordinary skill in the art will recognize that antifuse 10 may be fabricated as a part of the metallization sequence utilized in a standard double-metal CMOS process. The cell openings may be formed simultaneously with inter-metal contact vias in the process and the lower and upper antifuse electrodes may be formed simultaneously with the formation and definition of the first and second metal layers. The only additional steps required to form the antifuse of the present invention are the formation of pedestal 16 by use of a conventional masking and etching sequence, and the formation and definition of antifuse layer 22 and upper antifuse electrode by use of similar masking and etching steps.

While a presently-preferred embodiment of the invention has been disclosed, those of ordinary skill in the art will, from an examination of the within disclosure and drawing be able to configure other embodiments of the invention. These other embodiments are intended to fall within the scope of the present invention which is to be limited only by the scope of the appended claims.

## Claims

1. A process for fabricating a metal-to-metal antifuse (10), comprising the steps of:
forming and defining a first metal layer (18), comprising a lower antifuse electrode;
forming and planarizing an inter-metal dielectric layer (20);
forming an antifuse cell opening in said inter-metal dielectric layer; and
forming and defining an antifuse material layer (22) in said antifuse cell opening and an upper antifuse electrode over said antifuse material layer,
said process being characterized by the step of:
first forming a pedestal (16) in an insulating layer (14) on the surface of a substrate (12);
and in that:
at least a portion of said lower antifuse electrode is disposed on said pedestal; and
said upper antifuse electrode comprises at least a portion of a second metal layer (24) disposed over said antifuse material layer.

2. A process according to claim 1, further including the step of rounding the edges of said antifuse cell opening prior to forming said antifuse material layer (22).

3. A process according to claim 1 or 2, wherein said step of forming and defining said antifuse material layer (22) and said upper antifuse electrode comprises the steps of:
forming an antifuse material layer (22) over said inter-metal dielectrical layer;
forming an upper antifuse electrode over said antifuse material layer;
defining said upper antifuse electrode and said antifuse material layer substantially over said antifuse cell opening.

4. A process according to claim 1, 2 or 3 wherein said pedestal (16) is formed to a height of between about 0.2 to 0.6 microns and said inter-metal dielectric layer (20) is formed to a thickness on said pedestal (16) of about 0.4 microns and a thickness off said pedestal (16) of about 0.8 microns.

5. A process according to any one of claims 1 to 4, wherein said first metal layer (18) serves as a metal interconnect layer and said second metal layer (24) serves as a metal interconnect layer.

6. A metal-to-metal antifuse (10) in a microcircuit structure disposed on a substrate (12), comprising:
a lower antifuse electrode (18);
an inter-metal dielectric layer (20) disposed over said lower antifuse electrode (18), said inter-metal dielectric layer (20) having an antifuse cell opening disposed therein communicating with said lower antifuse electrode (18);
an antifuse material layer (22) disposed in said antifuse cell opening, characterized by:
a pedestal (16) disposed over and insulated from said substrate (12), said lower antifuse electrode (18) being disposed on said pedestal (16).

7. An antifuse according to claim 6, wherein:
said lower antifuse electrode (18) comprises a portion of a first metal interconnect layer in said microcircuit; and
said upper antifuse electrode comprises a portion of a second metal interconnect layer.

8. An antifuse according to claim 6 or 7, wherein:
said pedestal has a height of between about 0.2 to 0.6 microns and said inter-metal dielectric layer (20) has a thickness on said pedestal (16) of about 0.4 microns and a thickness off said pedestal (16) of about 0.8 microns.

## Patentansprüche

1. Verfahren zur Herstellung eines Schmelzschutzes (10) zwischen Metallen, das folgende Schritte unfaßt:
- Erzeugung und Bestimmung einer ersten Metallschicht (18), die eine untere Schmelzschutzelektrode umfaßt,
- Erzeugung und Ebnung einer intermetallischen dielektrischen Schicht (20),
- Erzeugung einer Schmelzschutzzellöffnung in der intermetallischen dielektrischen Schicht und
- Erzeugung und Bestimmung einer Schmelzschutmaterialschicht (22) in der Schmelzschutzzellöffnung und einer oberen Schmelzschutzelektrode über der Schmelzschutzmaterialschicht,
wobei dieses Verfahren durch folgenden Schritt gekennzeichnet ist:
- zunächst Erzeugung eines Sockels (16) in einer isolierenden Schicht (14) auf der Oberfläche eines Substrats (12),
und ferner dadurch gekennzeichnet ist, daß:
- mindestens ein Teil der unteren Schmelzschutzelektrode auf dem Sockel angebracht ist und
- die obere Schmelzschutzelektrode mindestens einen Teil einer zweiten, über der Schmelzschutzmaterialschicht angebrachten Metallschicht (14) umfaßt.

2. Verfahren nach Anspruch 1, gekennzeichnet durch einen weiteren Schritt, bei dem die Ränder der Schmelzschutzzellöffnung vor der Erzeugung der Schmelzschutzmaterialschicht (22) abgerundet werden.

3. Verfahren nach Anspruch 1 oder 2, dadurch gekennzeichnet, daß der Schritt der Erzeugung und Bestimmung der Schmelzschutzmaterialschicht (22) und der oberen Schmelzschutzelektrode die folgenden Schritte umfaßt:
- Erzeugung einer Schmelzschutzmaterialschicht (22) über der intermetallischen dielektrischen Schicht,
- Erzeugung einer oberen Schmelzschutzelektrode über der Schmelzschutzmaterialschicht,
- Bestimmung der oberen Schmelzschutzelektrode und der Schmelzschutzmaterialschicht im wesentlichen über der Schmelzschutzzellöffnung.

4. Verfahren nach Anspruch 1, 2 oder 3, dadurch gekennzeichnet, daß der Sockel (16) mit einer Stärke von ca. 0,2 bis 0,6 mµ erzeugt wird und die intermetallische dielektrische Schicht (20) mit einer Stärke ca. 0,4 mµ auf dem Sockel (16) und einer Stärke von ca. 0,8 mµ außerhalb des Sockels erzeugt wird.

5. Verfahren nach einem der Ansprüche 1 bis 4, dadurch gekennzeichnet, daß die erste Metallschicht (18) als eine Metallverbindungsschicht und die zweite Metallschicht (24) als eine Metallverbindungsschicht dient.

6. Schmelzschutz (10) zwischen Metallen in einer auf einem Substrat (12) angebrachten Mikroschaltkreisstruktur , der folgendes umfaßt:
- eine untere Schmelzschutzelektrode (18),
- eine intermetallische dielektrische Schicht (20), die über der unteren Schmelzschutzelektrode (18) angebracht ist, wobei die intermetallische dielektrische Schicht (20) darin eine Schmelzschutzzellöffnung aufweist, die mit der unteren Schmelzschutzelektrode (18) kommuniziert,
- eine in der Schmelzschutzzellöffnung angebrachte Schmelzschutzmaterialschicht (22), gekennzeichnet durch:
- einen Sockel (16), der über dem Substrat (12) angebracht und von ihm isoliert ist, wobei die untere Schmelzschutzelektrode (18) auf dem Sockel (16) angebracht ist.

7. Schmelzschutz nach Anspmch 6, dadurch gekennzeichnet, daß die untere Schmelzschutzelektrode (18) einen Teil einer ersten Metallverbindungsschicht in dem Mikroschaltkreis undaßt und die obere Schmelzschutzelektrode einen Teil einer zweiten Metallverbindungsschicht umfaßt.

8. Schmelzschutz nach Anspruch 6 oder 7, dadurch gekennzeichnet, daß der Sockel einen Stärke von ca. 0,2 bis 0,6 mµ aufweist und die intermetallische dielektrische Schicht (20) eine Stärke auf dem Sockel (16) von ca. 0,4 mµ und eine Stärke außerhalb des Sockels (16) von ca. 0,8 mµ aufweist.

## Revendications

1. Procédé de fabrication d'un antifusible métal-métal (10) comportant les étapes de :
formation et délimitation d'une première couche métallique (18) comprenant une électrode inférieure antifusible ;
formation et planarisation d'une couche diélectrique intermétallique (20) ;
formation, dans ladite couche diélectrique intermétallique, d'un évidement de cellule antifusible ; et
formation et délimitation d'une couche en matériau antifusible (22) dans ledit évidement de cellule antifusible et d'une électrode supérieure antifusible sur ladite couche en matériau antifusible,
ledit procédé étant caractérisé
en ce qu'il comprend une étape de formation préalable d'un socle (16) dans une couche isolante (14) à la surface d'un substrat (12) ;
en ce que :
une partie au moins de ladite électrode inférieure antifusible est disposée sur ledit socle ;
et en ce que
ladite électrode supérieure antifusible comprend au moins une partie d'une seconde couche métallique (24) disposée sur ladite couche en matériau antifusible.

2. Procédé selon la revendication 1, comportant en outre l'étape d'arrondissement des bords dudit évidement de cellule antifusible, avant la formation de ladite couche en matériau antifusible (22).

3. Procédé selon la revendication 1 ou 2, dans lequel ladite étape de formation et de délimitation de ladite couche en matériau antifusible (22) et de ladite électrode supérieure antifusible comporte les étapes de :
formation d'une couche en matériau antifusible (22) sur ladite couche diélectrique intermétallique ;
formation d'une électrode supérieure antifusible sur ladite couche en matériau antifusible ;
délimitation de ladite électrode supérieure antifusible et de ladite couche en matériau antifusible essentiellement sur ledit évidement de cellule antifusible.

4. Procédé selon l'une quelconque des revendications 1, 2 ou 3, dans lequel le socle (16) est formé avec une hauteur comprise entre 0,2 µm et 0,6 µm environ, ladite couche diélectrique intermétallique (20) étant formée avec une épaisseur de 0,4 µm environ sur ledit socle (16) et une épaisseur de 0,8 µm environ en dehors dudit socle (16).

5. Procédé selon l'une quelconque des revendications 1 à 4, dans lequel ladite première couche métallique (18) sert de couche métallique d'interconnexion et ladite seconde couche métallique (24) sert de couche métallique d'interconnexion.

6. Antifusible métal-métal (10) dans la structure d'un microcircuit disposé sur un substrat (12) comprenant :
une électrode inférieure antifusible (18) ;
une couche diélectrique intermétallique (20) disposée sur ladite électrode inférieure antifusible (18), ladite couche diélectrique intermétallique (20) comportant à l'intérieur un évidement de cellule antifusible qui communique avec ladite électrode inférieure antifusible (18) ;
une couche en matériau antifusible (22) disposée dans ledit évidement de cellule antifusible, caractérisé en ce que :
un socle (16) est disposé sur ledit substrat (12) et isolé par rapport à celui-ci, ladite électrode inférieure antifusible (18) étant disposée sur ledit socle (16).

7. Antifusible selon la revendication 6, dans lequel :
ladite électrode inférieure antifusible (18) comprend une partie d'une première couche métallique d'interconnexion dans ledit microcircuit ; et
ladite électrode supérieure antifusible comprend une partie d'une seconde couche métallique d'interconnexion.

8. Antifusible selon la revendication 6 ou 7, dans lequel :
ledit socle a une hauteur comprise entre 0,2 µm et 0,6 µm environ, et ladite couche diélectrique intermétallique (20) a une épaisseur de 0,4 µm environ sur ledit socle (16) et une épaisseur de 0,8 µm environ en dehors dudit socle (16).
